(19) Europäisches Patentamt
European Patent Office
Office européen des brevets

(11) Numéro de publication : **0 293 303 B1**

(12) **FASCICULE DE BREVET EUROPEEN**

(45) Date de publication du fascicule du brevet :
**06.03.91 Bulletin 91/10**

(51) Int. Cl.⁵ : **B01L 3/00**, B01L 11/00,
B64G 1/40, B01J 4/00

(21) Numéro de dépôt : **88401296.4**

(22) Date de dépôt : **27.05.88**

(54) **Vase d'expansion pour liquide, destiné à être utilisé en apesanteur.**

(30) Priorité : **29.05.87 FR 8707573**

(43) Date de publication de la demande :
**30.11.88 Bulletin 88/48**

(45) Mention de la délivrance du brevet :
**06.03.91 Bulletin 91/10**

(84) Etats contractants désignés :
**DE GB IT**

(56) Documents cités :
**EP-A- 0 043 777**
**EP-A- 0 132 175**
**US-A- 3 379 855**
**JOURNAL OF SPACECRAFT AND ROCKETS,**
**vol. 8, no. 2, février 1971, pages 83-98; S.C. DE**
**BROCK et al.: "A survey of current develop-**
**ments in surface tension devices for propel-**
**lant acquisition"**

(73) Titulaire : **AEROSPATIALE SOCIETE**
**NATIONALE INDUSTRIELLE Société**
**Anonyme dite:**
**37, Boulevard de Montmorency**
**F-75016 Paris (FR)**

(72) Inventeur : **Claramonte, Manuel Pierre**
**28, rue du Coteau**
**F-92370 Chaville (FR)**
Inventeur : **Martin, Gérard**
**34bis, rue Charles Tauchon**
**F-59300 Valenciennes (FR)**
Inventeur : **Auffret, Jean Claude**
**39, rue du Bout Malo**
**F-78130 Chapet (FR)**

(74) Mandataire : **Bonnetat, Christian et al**
**CABINET BONNETAT 23, Rue de Léningrad**
**F-75008 Paris (FR)**

## Description

La présente invention concerne un vase d'expansion pour liquide, destiné à être utilisé en apesanteur.

On sait que la manipulation de liquide en apesanteur est délicate et que, dans les installations destinées à fonctionner dans de telles conditions, il n'est pas possible d'utiliser des vases d'expansion de structure connue, lorsque cela est nécessaire. Cependant, on sait qu'il est parfois inévitable de manipuler des liquides en apesanteur, par exemple, pour réaliser des expériences dans des vaisseaux spatiaux. Des exemples de telles expériences sont par exemple constitués par la cristallogénèse de substances macromoléculaires, comme cela est décrit, par exemple, dans les demandes de brevet français N° 86 14056 du 9 Octobre 1986 (FR-A-2604917 publiée le 15.04.88) et N° 87 02947 du 4 Mars 1987 (FR-A-2611526 publiée le 09.09.88).

La présente invention a pour objet un vase d'expansion permettant de surmonter les difficultés soulevées par les conditions d'apesanteur.

A cette fin, selon l'invention, un vase d'expansion pour liquide en apesanteur, comportant des moyens d'amenée dudit liquide, est remarquable en ce qu'il comporte un corps absorbant pour ledit liquide et des moyens de conduction par tension superficielle, disposés entre lesdits moyens d'amenée du liquide et ledit corps absorbant.

Ainsi, lorsque du liquide pénètre dans le vase d'expansion, il est conduit par phénomène de tension superficielle par lesdits moyens de conduction jusqu'au corps absorbant.

Lorsque, comme cela est souvent souhaité, on désire que soit réalisée une séparation entre le liquide susceptible de pénétrer dans le vase d'expansion et le liquide ayant déjà pénétré dans ce dernier, il est avantageux que lesdits moyens d'amenée du liquide comportent un élément tubulaire en une matière non mouillante, espacé desdits moyens de conduction. Ainsi, le liquide pénétrant dans le vase d'expansion a tendance à former une goutte qui peut être captée par lesdits moyens de conduction. Bien entendu, la distance séparant ledit élément tubulaire desdits moyens de conduction, dépend de la viscosité du liquide à absorber. Il est avantageux que lesdits moyens de conduction comportent une pointe dirigée vers ledit élément tubulaire.

Afin d'offrir une large surface de conduction au liquide pénétrant dans le vase d'expansion, lesdits moyens de conduction comportent, de préférence, un ensemble d'ailettes réparties autour d'un axe, ladite pointe étant prévue axialement à une extrémité de l'ensemble desdites ailettes. Ainsi, le liquide capté par la pointe peut se répartir sur la surface des ailettes et être amené audit corps absorbant.

Afin de faciliter la conduction du liquide, il est avantageux que les chants des ailettes, adjacents à ladite pointe, soient pourvus de nervures et/ou de rigoles.

Par ailleurs, pour éviter les manipulations de liquide excédentaire, il est préférable que ledit corps absorbant soit disposé dans une partie amovible du vase. On peut donc, lorsque le corps absorbant est imprégné du liquide, effectuer le remplacement de ce corps absorbant en démontant la partie amovible dudit vase d'expansion, ce qui peut être réalisé sans contact avec le corps absorbant et le liquide qu'il contient. Il est alors aisé de mettre en place un nouveau corps absorbant, remplaçant le précédent.

Les figures du dessin annexé feront bien comprendre comment la présente invention peut être réalisée.

La figure 1 est une vue en coupe axiale d'un mode de réalisation du vase d'expansion conforme à la présente invention.

La figure 2 est une coupe transversale selon la ligne II-II de la figure 1.

La figure 3 est une vue en perspective des moyens de conduction par tension superficielle, disposés à l'intérieur du vase d'expansion des figures 1 et 2.

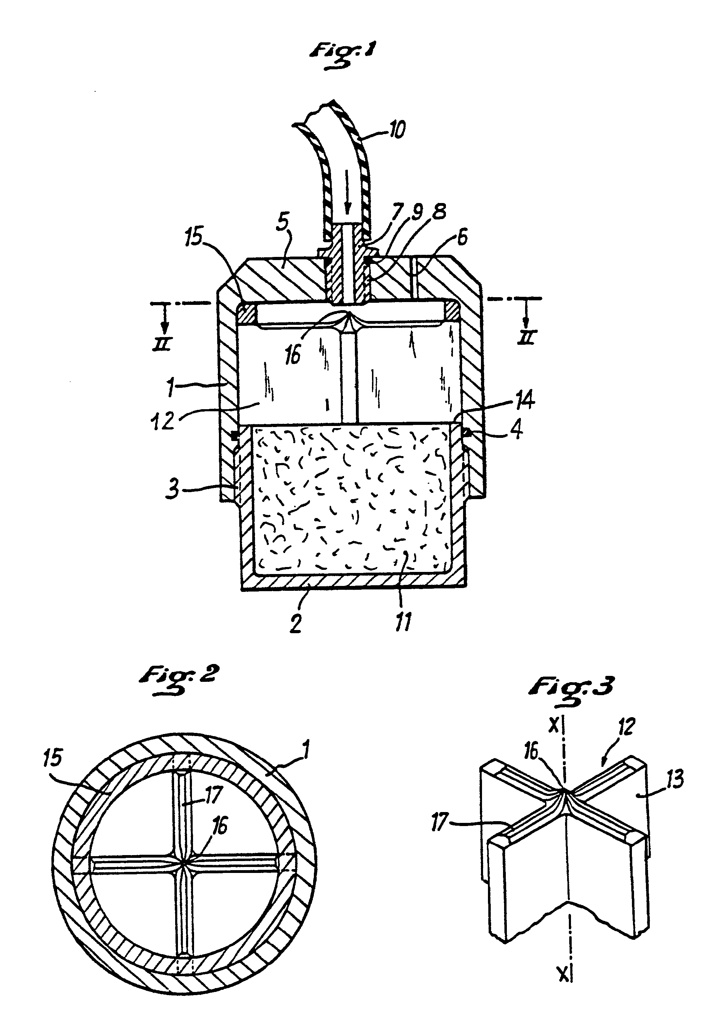

Le vase d'expansion pour liquide en apesanteur, représenté sur ces figures, est constitué d'un réceptacle 1 et d'une partie amovible 2 pouvant être assemblés de façon étanche, par exemple, par un filetage 3 et un joint 4, audit réceptacle 1.

Dans le fond 5 du réceptacle 1, opposé à ladite partie amovible 2, est percé un orifice 6 destiné à mettre la cavité intérieure du réceptacle 1 à la pression extérieure. De plus, dans le fond 5 est disposé un embout 7, en une matière non mouillante pour le liquide destiné à être stocké dans le vase d'expansion. Cet embout 7 est monté de façon étanche dans ledit fond 5, par exemple, grâce à un filetage 8 et à un joint 9. Sur l'embout 7 peut s'emmancher une tubulure 10.

Dans la partie amovible 2 du vase d'expansion selon l'invention est disposé un corps spongieux 11, susceptible d'absorber le liquide à stocker.

De plus, entre l'embout 7 et le corps absorbant 11 sont prévus des moyens de conduction 12 constitués d'une pluralité d'ailettes 13 concourantes selon un axe X-X. L'ensemble 12 des ailettes 13 est réalisé en une matière mouillante pour le liquide à stocker. L'ensemble 12 des ailettes 13 est bloqué entre le bord 14 de la partie amovible 2 et une entretoise annulaire 15 prenant appui sur le fond 5 du réceptacle 1.

Les chants des ailettes 13 de l'ensemble 12, en regard du fond 5, sont prolongés vers l'embout 7 par une pointe 16. L'épaisseur de l'entretoise annulaire 15 permet de régler la distance entre la pointe 16 et l'embout 7. De plus, ces chants sont pourvus de nervures 17 facilitant la conduction du liquide à stocker. Ainsi, lorsque du liquide est amené, en apesanteur, par la tubulure 10 (par exemple sous l'action d'une légère pression) ce liquide forme à l'extrémité de l'embout 7, une goutte qui, lorsqu'elle entre en contact avec la pointe 16, est attirée par les nervures 17 et se répartit par effet de tension superficielle le long des faces des ailettes 13. Par suite, ce liquide est conduit jusqu'au corps absorbant 11 qu'il imprègne. Lorsque ce corps absorbant est saturé de liquide, il est possible de démonter la partie amovible 2 du réceptacle 1 et, soit de la remplacer par une nouvelle partie amovible 2 comportant un nouveau corps absorbant 11, soit de remettre en place la partie amovible 2 démontée, après avoir remplacé le corps absorbant 11 usagé par un nouveau. L'élimination du corps absorbant 11 saturé de la partie amovible 2 peut être effectuée sans contact physique avec le liquide imprégnant ce corps absorbant.

## Revendications

1. Vase d'expansion (1, 2) pour liquide en apesanteur, comportant des moyens d'amenée (7, 10) dudit liquide, caractérisé en ce qu'il comporte un corps (11) absorbant pour ledit liquide et des moyens (12) de conduction par tension superficielle disposés entre lesdits moyens d'amenée du liquide et ledit corps absorbant.

2. Vase d'expansion selon la revendication 1, caractérisé en ce que lesdits moyens (7, 10) d'amenée du liquide comportent un élément tubulaire (7) en une matière non mouillante, espacé desdits moyens de conduction (12).

3. Vase d'expansion selon la revendication 2, caractérisé en ce que lesdits moyens de conduction (12) comportent une pointe (16) dirigée vers ledit élément tubulaire (7).

4. Vase d'expansion selon la revendication 3, caractérisé en ce que lesdits moyens de conduction (12) comportent un ensemble d'ailettes (13) réparties autour d'un axe, ladite pointe (16) étant prévue axialement à une extrémité de l'ensemble desdites ailettes.

5. Vase d'expansion selon la revendication 3, caractérisé en ce que les chants des ailettes (13) adjacents à ladite pointe sont pourvus de nervures et/ou de rigoles (17).

6. Vase d'expansion selon l'une quelconque des revendications 1 ou 2, caractérisé en ce que ledit corps absorbant (11) est disposé dans une partie amovible (2) dudit vase.

## Ansprüche

1. Expansionsbehälter (1, 2) für Flüssigkeiten zur Benutzung bei Schwerelosigkeit mit einer Einrichtung (7, 10) zum Zuführen der Flüssigkeiten, dadurch gekennzeichnet, daß er einen absorbierenden Körper (11) für die Flüssigkeit und eine Einrichtung (12) zum Leiten durch Oberflächenspannung aufweist, die zwischen der Einrichtung zum Zuführen der Flüssigkeit und dem absorbierenden Körper angeordnet ist.

2. Expansionsbehälter nach Anspruch 1, dadurch gekennzeichnet, daß die Einrichtung (7, 10) zum Zuführen der Flüssigkeit ein röhrenförmiges Teil (7) aus nicht an- oder befeuchtendem Werkstoff räumlich getrennt von der Einrichtung (12) zum Leiten aufweist.

3. Expansionsbehälter nach Anspruch 2, dadurch gekennzeichnet, daß die Einrichtung (12) zum Leiten eine Spitze (16) aufweist, die zum röhrenförmigen Teil (7) weist.

4. Expansionsbehälter nach Anspruch 3, dadurch gekennzeichnet, daß die Einrichtung (12) zum Leiten einen Flügelsatz (13) aufweist, die um eine Achse verteilt angeordnet sind, wobei die Spitze (16) axial an einem Ende des Flügelsatzes vorgesehen ist.

5. Expansionsbehälter nach Anspruch 3, dadurch gekennzeichnet, daß die Hochkanten der Flügel (13) in der Nähe der Spitze mit Rippen und/oder Rinnen (17) versehen sind.

6. Expansionsbehälter nach einem der vorhergehenden Ansprüche 1 oder 2, dadurch gekennzeichnet, daß der absorbierende Körper (11) in einem abnehmbaren Teil (2) des Behälters angeordnet ist.

## Claims

1. Expansion vessel (1, 2) for liquid in weightlessness, comprising liquid feeding means (7, 10), characterized in that it comprises an absorbing body (11) for said liquid and surface tension conducting means (12) located between said liquid feeding means and said absorbing body.

2. Expansion vessel according to claim 1, characterized in that said liquid feeding means (7, 10) comprise a tubular element (7) in a non-wetting material, spaced apart from said conducting means (12).

3. Expansion vessel according to claim 2, characterized in that said conducting means (12) comprise a point (16) directed towards said tubular element (7).

4. Expansion vessel according to claim 3, characterized in that said conducting means (12) comprise a plurality of fins (13) distributed about an axis, said point (16) being disposed axially at one end of the plurality of said fins.

5. Expansion vessel according to claim 3, characterized in that the edges of the fins (13) adjacent to said point are provided with ribs and/or channels (17).

6. Expansion vessel according to any one of claims 1 or 2, characterized in that said absorbing body (11) is disposed in a removable part (2) of said vessel.

*Fig.1*

*Fig.2*

*Fig.3*

4